(19) Europäisches Patentamt
European Patent Office
Office européen des brevets

(11) **EP 1 239 590 B1**

(12) **EUROPÄISCHE PATENTSCHRIFT**

(45) Veröffentlichungstag und Bekanntmachung des Hinweises auf die Patenterteilung:
**23.09.2009  Patentblatt 2009/39**

(51) Int Cl.:
***H03J 7/04*** *(2006.01)*

(21) Anmeldenummer: **02003863.4**

(22) Anmeldetag: **21.02.2002**

(54) **Verfahren und Phasenregelkreis zur Synchronisation auf einen in einem Nutzsignal enthaltenen Hilfsträger**

Method and phase locked loop for synchronization to a subcarrier that is comprised in a wanted signal

Méthode et boucle à verrouillage de phase pour la synchronisation sur une sous-porteuse qui est comprise dans un signal utile

(84) Benannte Vertragsstaaten:
**AT BE CH CY DE DK ES FI FR GB GR IE IT LI LU MC NL PT SE TR**

(30) Priorität: **09.03.2001  DE 10111402**

(43) Veröffentlichungstag der Anmeldung:
**11.09.2002  Patentblatt 2002/37**

(73) Patentinhaber: **Harman Becker Automotive Systems GmbH**
**76307 Karlsbad (DE)**

(72) Erfinder:
• **Gierl, Stefan**
**76133 Karlsruhe (DE)**
• **Benz, Christoph**
**77797 Ohlsbach (DE)**

(74) Vertreter: **Patentanwälte**
**Westphal, Mussgnug & Partner**
**Am Riettor 5**
**78048 Villingen-Schwenningen (DE)**

(56) Entgegenhaltungen:
| | |
|---|---|
| EP-A- 0 512 606 | EP-A- 0 594 403 |
| EP-A2- 0 516 379 | DE-A1- 19 738 914 |
| GB-A- 2 135 844 | US-A- 4 703 340 |

**Beschreibung**

Die Erfindung betrifft ein Verfahren zur Synchronisation auf einen in einem Nutzsignal enthaltenen Hilfsträger.

Die Erfindung betrifft weiter einen Phasenregelkreis zur Synchronisation auf einen in einem Nutzsignal enthaltenen Hilfsträger.

UKW-Rundfunksender senden das sogenannte Stereomultiplexsignal aus, das aus dem Audiomittensignal - auch Monosignal genannt - bis 15 KHz, dem Stereopilotton bei 19 KHz, dem Stereosignal von 23 KHz bis 53 KHz, dem ARI-Signal, -einem schmalbandigen amplitudenmodulierten Signal bei 57 KHz, und dem RDS-Signal gebildet wird.

ARI ist die Abkürzung für Autofahrer-Rundfunk-Information. RDS steht für Radio-Daten-System.

Die EP 0 512 606 A2 beschreibt einen Stereoreceiver mit einem digitalen Stereodecoder in dem ein zeitdiskretes Basisband-Stereomultiplexsignal effizient ausgewählt und dekodiert werden kann,

Die DE 197 38 914 A1 beschreibt einen digitalen Phasenregelkreis mit erhöhter Zeitauflösung.

Die US 4,703,340 betrifft einen Analog-Digital-Wandler und die EP 0:516 379 A2 digitale VCOs (Voltage-Controlled-Oszillators).

Zur Demodulation des Stereomultiplexsignals ist eine Synchronisation auf den als Hilfsträger dienenden Pilotton von 19 KHz erforderlich, die bei jeder Einstellung auf einen neuen Sender möglichst schnell und genau erfolgen soll.

Es ist daher Aufgabe der Erfindung, ein Verfahren und einen Phasenregelkreis zur Synchronisation auf einen im Nutzsignal enthaltenen Hilfsträger so zu gestalten, daß eine schnelle und genaue Synchronisation erzielt wird.

Verfahrensmäßig wird diese Aufgabe mit den im Anspruch 1 angegebenen Merkmalen gelöst.

Schaltungsmäßig wird diese Aufgabe mit den im Anspruch 11 angegebenen Merkmalen dadurch gelöst, daß das Nutzsignal am ersten Eingang eines Multiplizierers liegt, daß die Quadraturkomponente des von einem digitalen Oszillator erzeugten Hilfsträgers am zweiten Eingang des Multiplizierers liegt, dessen Ausgang mit dem Eingang eines Tiefpasses verbunden ist, und daß das Ausgangssignal des Tiefpasses zur Steuerung des digitalen Oszillators vorgesehen ist.

Der Oszillator ist aus einer Tabelle der Länge N und einem Zähler aufgebaut, der zur Adressierung der Tabelleneinträge dient. Die Tabelleneinträge sind ganze Zahlen zu je n Bits. Die Tabelleneinträge werden mit einer vorgebbaren Schrittweite Δn ausgelesen .

Die Erfindung sieht vor, daß ein Tabelleneintrag LUT(n), der an der Adresse n steht, nach folgender Vorschrift gebildet wird:

$$LUT(n) = NINT(2^{(nbit-1)} \cdot \sin(2\pi n/N)),$$

wobei n eine ganze Zahl zwischen 0 und N-1 ist,
wobei N die Länge der Tabelle ist,
wobei nbit die Wortlänge eines Tabelleneintrages ist und
wobei der Operator NINT die Rundung auf die nächste größere ganze Zahl bedeutet.

Das erfindungsgemäße Verfahren sieht vor, das Nutzsignal, z. B. das Stereomultiplexsignal eines UKW-Rundfunksenders, mit der Quadraturkomponente des von einem digitalen Oszillator erzeugten Hilfsträgers - dem Pilotton mit einer Frequenz von 19 KHz - in einem Multiplizierer zu multiplizieren. Das resultierende Signal stellt ein erstes Regelsignal dar, das nach Filterung mittels eines Tiefpasses der Regelung des digitalen Oszillators dient.

Zur Einstellung des Nullphasenwinkels $\varphi_0$ am digitalen Oszillator ist ein Zähleroffset $n_0$ vorgesehen. Der korrekte Nullphasenwinkel $\varphi_0$ wird daher durch Inkrementieren oder Dekrementieren des Zählers eingestellt.

Um ein Sinussignal der Frequenz $f_0$, z. B. der Pilotton mit einer Frequenz von 19 KHz, bei einer Abtastfrequenz $f_A$ von z. B. 176,4 KHz zu erzeugen, werden die Tabelleneinträge aus der Tabelle mit einer Schrittweite Δn ausgelesen, die z. B. nach folgender Formel berechnet wird:

$$\Delta n = NINT(N \cdot (f_0/f_A))$$

Für eine Tabelle der Länge N = 256 ergibt sich beispielsweise eine Schrittweite Δn von 110.

Um den Nullphasenwinkel $\varphi_0$ am Zähler einstellen zu können, ist ein Zähleroffset $n_0$ vorgesehen, der nach folgender Formel berechnet wird:

$$n_0 \quad = \quad \text{NINT}((\varphi_0/2\pi) \cdot N)$$

Ein weiteres Ausführungsbeispiel der Erfindung sieht einen zeitvariablen Offset $n_0(k)$ des Zählers vor. Der Zählerstand $n(k)$ zum Zeitpunkt $k^*T_A$, wobei $T_A = 1/f_A$, wird nach folgender Formel berechnet:

$$n(k) = (n(k-1) + \Delta n + n_0(k)) \bmod N$$

Um die Anhäufung von Rundungsfehlern bei der Berechnung der Adressen der Tabelleneinträge zu minimieren, sieht ein weiteres Ausführungsbeispiel eine virtuelle Tabelle mit einer Länge N' vor, die wesentlich größer gewählt ist als die Länge N der realen Tabelle. Beispielsweise ist die virtuelle Tabellenlänge N' 64-mal so groß gewählt wie die Tabellenlänge N.

Alle Berechnungen der Zählerstände und der Adressen werden nach den zuvor angegebenen Formeln für die virtuelle Tabelle der Länge N' berechnet. Für den Zugriff auf die reale Tabelle werden jedoch nur die entsprechenden Most Significant Bits des aktuellen Zählerstandes $n(k)$ genutzt, die dem Adreßraum der realen Tabelle der Länge N entsprechen.

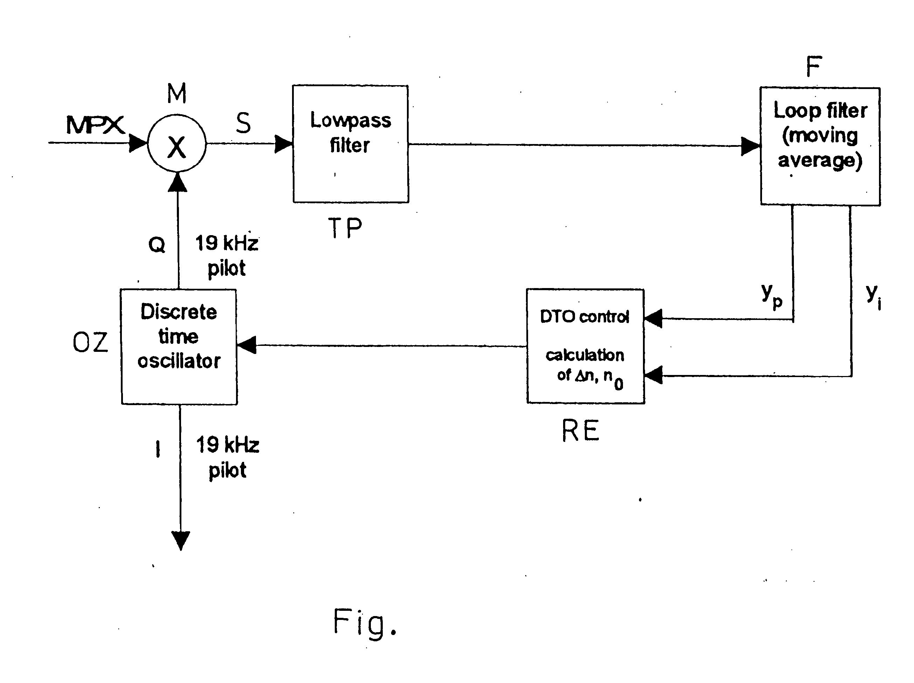

Das erfindungsgemäße Verfahren und der erfindungsgemäße Phasenregelkreis werden anhand eines in der Figur gezeigten Ausführungsbeispieles eines erfindungsgemäßen Phasenregelkreises näher beschrieben und erläutert.

Bei dem in der Figur abgebildeten Ausführungsbeispiel eines erfindungsgemäßen Phasenregelkreises liegt das Nutzsignal, z. B. das Stereomultiplexsignal MPX, am ersten Eingang eines Multiplizierers M, dessen Ausgang mit dem Eingang eines Tiefpasses TP verbunden ist, dessen Ausgang an den Eingang eines Schleifenfilters F angeschlossen ist. Die Quadraturkomponente Q des von einem digitalen Oszillator OZ erzeugten Hilfsträgers, dem Pilotton bei 19 KHz, liegt am zweiten Eingang des Multiplizierers M. Der erste und der zweite Steuerausgang des Schleifenfilters F sind mit einer Recheneinheit RE verbunden, deren Ausgang mit dem Steuereingang des digitalen Oszillators OZ verbunden ist.

Im Multiplizierer M wird das Stereomultiplexsignal MPX mit der Quadraturkomponente Q des vom digitalen Oszillator OZ erzeugten Pilottones multipliziert. Das resultierende Signal S stellt ein erstes Regelsignal dar, das mittels des Tiefpasses TP tiefpaßgefiltert wird. Aus diesem tiefpaßgefilterten ersten Regelsignal erzeugt das Schleifenfilter F ein zweites Regelsignal $y_p$, das proportional zum ersten Regelsignal S ist, und ein drittes Regelsignal $y_i$, das zeitlich aus dem ersten Regelsignal S gemittelt wird.

Aus dem zweiten Regelsignal $y_p$ und dem dritten Regelsignal $y_i$ berechnet die Recheneinheit RE den Offset $n_0(k)$ für den Zähler des digitalen Oszillators OZ nach folgender Formel:

$$n_0(k) = \text{NINT}(c_p \cdot y_p \cdot (N`/2\pi) + c_i \cdot y_i \cdot (N`/2\pi))$$

Die Konstanten $c_p$ und $c_i$ beeinflussen das Regelverhalten des Phasenregelkreises. Durch geeignete Wahl dieser Konstanten $c_p$ und $c_i$ läßt sich der Phasenregelkreis ähnlich wie ein PI-Regler beeinflussen. Weil die Regelung der Phase des vom digitalen Oszillator OZ erzeugten Pilottons über den zeitvariablen Offset $n_0(k)$ erfolgt, ergibt sich ein ebenfalls zeitlich veränderliches Inkrement für den Zugriff auf die Tabelle des Zählers.

Um den Speicherplatzbedarf in der Tabelle des Oszillators zu reduzieren, genügt es, lediglich eine viertel Periode eines Sinussignals zu speichern. Als Nachteil muß aber in Kauf genommen werden, daß die Berechnungen der Adressen aufwendiger ausfallen.

Die Synchronisation des im Stereomultiplexsignal MPX enthaltenen Pilottons mit dem vom digitalen Oszillator OZ erzeugten Pilotton ist erzielt, sobald das erste Regelsignal S zu Null wird. Dies ist der Fall, wenn die Quadraturkomponente Q des vom digitalen Oszillator OZ erzeugten Pilottons in Quadratur zu dem im Stereomultiplexsignal MPX enthaltenen Pilotton steht.

Das erfindungsgemäße Verfahren und der erfindungsgemäße Phasenregelkreis zeichnen sich durch den ersten Vorteil einer sehr schnellen Synchronisation aus. Mit anderen Worten ausgedrückt bedeutet dies, daß der erfindungsgemäße Phasenregelkreis sehr schnell einrastet. Ein zweiter Vorteil des erfindungsgemäßen Verfahrens liegt darin, daß das Verfahren als Software realisierbar ist.

Die Erfindung ist für Stereorundfunkempfänger, insbesondere für Autoradios, geeignet.

Bezugszeichenliste

| | |
|---|---|
| F | Schleifenfilter |
| I | Kophasalkomponente |
| M | Multiplizierer |
| MPX | Stereomultiplexsignal |
| OZ | digitaler Oszillator |
| Q | Quadraturkomponente |
| RE | Recheneinheit |
| S | Regelsignal |
| TP | Tiefpaß |
| $y_i$ | Regelsignal |
| $y_p$ | Regelsignal |

**Patentansprüche**

1. Verfahren zur Synchronisation auf einen in einem Nutzsignal (MPX) enthaltenen Hilfsträger, wobei
   das Nutzsignal (MPX) mit der Quadraturkomponente (Q) des von einem digitalen Oszillator (OZ) erzeugten Hilfsträgers multipliziert wird, wobei
   das resultierende Signal (S) - ein erstes Regelsignal - tiefpaßgefiltert wird und daß das tiefpaßgefilterte erste Regelsignal den Oszillator (OZ) regelt, wobei
   der Oszillator (OZ) aus einer Tabelle der Länge (N) und einem Zähler aufgebaut wird, welcher zur Adressierung der Tabelleneinträge dient, wobei
   die Tabelleneinträge mit einer vorgebbaren Schrittweite ($\Delta$n) ausgelesen werden,
   **dadurch gekennzeichnet, daß** ein Tabelleneintrag LUT(n), der an der Adresse n steht, nach folgender Formel gebildet wird:

$$\mathtt{LUT(n)\ =\ NINT(2^{(nbit-1)}\ \cdot\ sin(2\pi n/N)),}$$

   wobei n eine ganze Zahl zwischen 0 und N-1 ist,
   wobei N die Länge der Tabelle ist,
   wobei nbit die Wortlänge eines Tabelleneintrags ist und
   wobei der Operator NINT die Rundung auf die nächstgrößere ganze Zahl bedeutet.

2. Verfahren nach Anspruch 1,
   **dadurch gekennzeichnet, daß** die Tabelleneinträge ganze Zahlen zu je n Bits sind.

3. Verfahren nach Anspruch 1 oder 2,
   **dadurch gekennzeichnet, daß** der Nullphasenwinkel $\phi$0 am Oszillator (OZ) durch einen Offset $n_o$ des Zählers durch Inkrementieren oder Dekrementieren des Zählers eingestellt wird.

4. verfahren nach einem der Ansprüche 1 bis 3,
   **dadurch gekennzeichnet, daß** zur Erzeugung eines Sinussignals der Frequenz $f_0$ bei einer Abtastfrequenz $f_A$ die

Schrittweite $\Delta n$ nach folgender Formel bestimmt wird:

$$\Delta n = NINT(N \cdot (f_0/f_A)),$$

wobei der Operator NINT die Rundung auf die nächstgrößere ganze Zahl bedeutet.

5. Verfahren nach einem der Ansprüche 1 bis 4,
**dadurch gekennzeichnet, daß** der Offset $n_o$ des zählers aus dem Nullphasenwinkel $\varphi 0$ nach folgender Formel berechnet wird:

$$n_0 = NINT((\varphi_0/2\pi) \cdot N)$$

6. Verfahren nach einem der Ansprüche 1 bis 5,
**dadurch gekennzeichnet, daß** der Zählerstand $n(k)$ zum Zeitpunkt $k*T_A$, wobei $T_A = 1/f_A$ und $f_A$ die Abtastfrequenz ist, nach folgender Formel berechnet wird:

$$n(k) = (n(k-1) + \Delta n + n_0(k)) \ modulo \ N$$

7. Verfahren nach einem der Ansprüche -1 bis 6,
**dadurch gekennzeichnet, daß** mit einer virtuellen Tabelle der Länge N', die größer ist als die Länge N der realen Tabelle, gearbeitet wird, daß alle Zählerstands- und Adreßberechnungen für die virtuelle Tabellenlänge N' durchgeführt werden, daß für den Zugriff auf die reale Tabelle jedoch nur die entsprechenden Most Significant Bits des aktuellen zählerstandes $n(k)$ genutzt werden, die dem Adreßraum der realen Tabelle der Länge N entsprechen.

8. Verfahren nach einem der Ansprüche 1 bis 7,
**dadurch gekennzeichnet, daß** das tiefpaßgefilterte Regelsignal einem Schleifenfilter (F) zugeführt wird, daß ein zweites zum ersten Regelsignal (S) proportionales Regelsignal ($y_p$) und ein drittes Regelsignal ($y_i$) erzeugt, das zeitlich aus dem ersten Regelsignal (S) gemittelt wird, und daß aus dem zweiten und dritten Regelsignal ($y_p$, $y_i$) der Offset $n_0(k)$ des zählers nach folgender Formel berechnet wird:

$$n_0(k) = NINT(c_p \cdot y_p \cdot (N'/2\pi) + c_i \cdot y_i \cdot (N'/2\pi)),$$

wobei $c_p$ und $c_i$ Konstanten zur Beeinflussung des Reglerverhaltens sind.

9. Verfahren nach einem der Ansprüche 1 bis 8,
**dadurch gekennzeichnet, daß** zur Reduzierung des Speicherplatzbedarfs in der Tabelle des Zählers nur eine viertel Periode eines Sinussignals gespeichert wird.

10. Verfahren nach einem der Ansprüche 1 bis 9,
**dadurch gekennzeichnet, daß** das Verfahren als Software realisiert ist.

11. Phasenregelkreis zur Synchronisation auf einen in einem Nutzsignal (MPX) enthaltenen Hilfsträger, wobei das Nutzsignal am ersten Eingang eines Multiplizieres (M) liegt, wobei die Quadraturkomponente (Q) des von einem digitalen Oszillator (OZ) erzeugten ersten Hilfsträgers am zweiten Eingang des Multiplizierers (M) liegt, dessen Ausgang mit den Eingängen eines Tiefpasses (TP) verbunden ist, wobei das Ausgangssignal des Tiefpasses (TP) zur Steuerung des Oszillators (OZ) vorgesehen ist, wobei der Oszillator (OZ) aus einer Tabelle der Länge (N) und einem Zähler aufgebaut ist, welche zur Adressierung der Tabelleneinträge dient, wobei die Tabelleneinträge mit einer vorgebbaren Schrittweite $\Delta n$ auslesbar sind, **dadurch gekennzeichnet, daß** ein Tabelleneintrag (LUT(n)), der an der Adresse n steht, nach folgender Vorschrift

gebildet ist:

$$LUT(n) = NINT(2^{(nbit-1)} \cdot \sin(2\pi n/N)),$$

wobei n eine ganze Zahl zwischen 0 und N-1 ist,
wobei N die Länge der Tabelle ist,
wobei nbit die Wortlänge eines Tabelleneintrags ist und
wobei der Operator NINT die Rundung auf die nächste ganze Zahl bedeutet.

12. Phasenregelkreis nach Anspruch 11,
**dadurch gekennzeichnet, daß** der Ausgang des Tiefpasses (TP) mit dem Eingang eines Schleifenfilters (F) verbunden ist, dessen erster und zweiter Ausgang mit einer Recheneinheit (RE) verbunden sind, und dai3 der Ausgang der Recheneinheit (RE) mit dem Steuereingang des Oszillators (OZ) verbunden ist.

13. Phasenregelkreis nach Anspruch 11,
**dadurch gekennzeichnet, daß** die Tabelleneinträge ganze Zahlen zu je n Bits sind.

14. Phasenregelkreis nach Anspruch 11, 12 oder 13,
**dadurch gekennzeichnet, daß** der Nullphasenwinkel ($\varphi_0$ am Oszillator (OZ) durch einen Offset $n_0$ des Zählers durch Inkrementieren oder Dekrementieren des Zähler einstellbar ist.

15. Phasenregelkreis nach einem der Ansprüche 11 bis 14,
**dadurch gekennzeichnet, daß** zur Erzeugung eines Sinussignales der Frequenz $f_o$ bei einer Abtastfrequenz $f_A$ die Schrittweite $\Delta n$ nach folgender Formel bestimmt ist:

$$\Delta n = NINT(N \cdot (f_o/f_A)),$$

wobei der Operator NINT die Rundung auf die nächste größere ganze Zahl bedeutet.

16. Phasenregelkreis nach einem der Ansprüche 11 bis 15,
**dadurch gekennzeichnet, daß** der Offset $n_0$ des Zählers aus dem Nullphasenwinkel $\varphi_0$ nach folgender Formel berechnet ist:

$$N_0 = NINT((\varphi_0/2\pi) \cdot N)$$

17. Phasenregelkreis nach einem der Ansprüche 11 bis 16,
**dadurch gekennzeichnet, daß** der Zählerstand n(k) zum Zeitpunkt k*$T_A$, wobei $T_A$ = 1/$f_A$ und $f_A$ die Abtastfrequenz ist, nach folgender Formel berechnet ist:

$$n(k) = (n(k-1) + \Delta n + n_0(k)) \text{ modulo } N$$

18. Phasenregelkreis nach einem der Ansprüche 11 bis 17,
**dadurch gekennzeichnet, daß** eine virtuelle Tabelle der Länge N' vorgesehen ist, die größer als die Länge N der realen Tabelle ist, daß alle Zählerstands- und Adreßberechnungen für die virtuelle Tabellenlänge N' berechnet sind, daß für den Zugriff auf die reale Tabelle jedoch nur die entsprechenden Most Significant Bits des aktuellen Zählerstandes n(k) genutzt sind, die dem Adreßraum der realen Tabelle der Länge N entsprechen.

19. Phasenregelkreis nach Anspruch 18,
**dadurch gekennzeichnet, daß** der Zählerstand $n_0$(k) nach folgender Formel berechnet ist:

$$n_0(k) = NINT(c_p \cdot y_p \cdot (N'/2\pi) + c_i \cdot y_i \cdot (N'/2\pi)),$$

wobei $y_p$ ein vom Schleifenfilter (F) erzeugtes zum ersten Regelsignal (S) proportionales zweites Regelsignal ist,
wobei $y_i$ ein vom Schleifenfilter (F) erzeugtes aus dem ersten Regelsignal (S) zeitlich gemitteltes drittes Regelsignal ist,
und wobei $c_p$ und $c_i$ Konstanten zur Beeinflussung des Regelverhaltens des Phasenregelkreises sind.

20. Phasenregelkreis nach einem der Ansprüche 11 bis 19,
    **dadurch gekennzeichnet, daß** zur Reduzierung des Speicherplatzbedarfs in der Tabelle des Zählers nur eine viertel Periode eines Sinussignals gespeichert ist.

21. Verfahren oder Phasenregelkreis nach einem der Ansprüche 1 bis 10,
    **dadurch gekennzeichnet, daß** das Nutzsignal (MPX) das Stereomultiplexsignal und der Hilfsträger der Pilotton mit einer Frequenz von 19 KHz ist.

**Claims**

1. Method for synchronisation with a subcarrier contained in a useful signal (MPX),
   wherein the useful signal (MPX) is multiplied by the quadrature component (Q) of the subcarrier generated by a digital oscillator (OZ), wherein the resulting signal (S) - a first control signal - is low-pass filtered and the low-pass filtered first control signal controls the oscillator (OZ), wherein the oscillator (OZ) is made up of a table of the length (N) and a counter which serves for addressing the table entries, wherein the table entries are read out with a predeterminable increment ($\Delta$n), **characterised in that** a table entry LUT(n) located at the address n is formed according to the following equation:

$$LUT(n) = NINT(2^{(nbit-1)} \cdot \sin(2\pi n/N)),$$

   wherein n is an integer between 0 and N-1,
   wherein N is the length of the table,
   wherein nbit is the word length of a table entry, and
   wherein the operator NINT signifies rounding to the next higher integer.

2. Method as claimed in Claim 1, **characterised in that** the table entries are integers of n bits each.

3. Method as claimed in either Claim 1 or Claim 2, **characterised in that** the zero phase angle $\varphi 0$ at the oscillator (OZ) is set by an offset $n_0$ of the counter by incrementation or decrementation of the counter.

4. Method as claimed in any one of Claims 1 to 3, **characterised in that** for generation of a sinusoidal signal of frequency $f_0$ at a scanning frequency of $f_A$ the increment $\Delta$n is determined according to the following equation:

$$\Delta n = NINT(N \cdot (f_0/f_A))$$

   wherein the operator NINT signifies rounding to the next higher integer.

5. Method as claimed in any one of Claims 1 to 4, **characterised in that** the offset no of the counter is calculated from the zero phase angle $\varphi 0$ according to the following equation:

$$n_0 = NINT((\varphi_0/2\pi) \cdot N).$$

6. Method as claimed in any one of Claims 1 to 5, **characterised in that** at the time k*TA, where $T_A = 1/f_A$ and $f_A$ is the scanning frequency, the counter reading n(k) is calculated according to the equation:

$$n(k) = (n(k-1) + \Delta n + n_0(k)) \text{ modulo } N.$$

7. Method as claimed in any one of Claims 1 to 6, **characterised in that** a virtual table is used with a length N' which is greater than the length N of the real table, that all counter reading and address calculations are carried out for the virtual table length N', but that only the corresponding most significant bits of the current counter reading n(k) which match the address space of the real table of length N are used for access to the real table.

8. Method as claimed in any one of Claims 1 to 7, **characterised in that** the low-pass filtered control signal is supplied to a loop filter (F) which generates a second control signal ($y_p$) proportional to the first control signal (S) and a third control signal ($y_i$) which is averaged over time from the first control signal (S), and that the offset $n_0(k)$ of the counter is calculated from the second and third control signals ($y_p$, $y_i$) according to the equation:

$$n_0(k) = NINT(c_p \cdot y_p \cdot (N'/2\pi) + c_i \cdot y_i \cdot (N'/2\pi)),$$

wherein $c_p$ and $c_i$ are constants for influencing the controller behaviour.

9. Method as claimed in any one of Claims 1 to 8, **characterised in that** in order to reduce the memory requirement in the table of the counter only a quarter period of a sinusoidal signal is stored.

10. Method as claimed in any one of Claims 1 to 9, **characterised in that** the method is implemented as software.

11. Phase-locked loop for synchronisation with a subcarrier contained in a useful signal (MPX), wherein the useful signal is present at the first input of a multiplier (M), wherein the quadrature component (Q) of the first subcarrier generated by a digital oscillator (OZ) is present at the second input of the multiplier (M), the output of which is connected to the inputs of a low-pass filter (TP), wherein the output signal of the low-pass filter (TP) is provided for control of the oscillator (OZ), wherein the oscillator (OZ) is made up of a table of length (N) and a counter which serves for addressing the table entries, wherein the table entries can be read out with a predeterminable increment $\Delta n$, **characterised in that** a table entry (LUT(n)) which is located at the address n is formed according to the following equation:

$$LUT(n) = NINT(2^{(nbit-1)} \cdot \sin(2\pi n/N))$$

wherein n is an integer between 0 and N-1,
wherein N is the length of the table,
wherein nbit is the word length of a table entry and
wherein the operator NINT signifies rounding to the next higher integer.

12. Phase-locked loop as claimed in Claim 11, **characterised in that** the output of the deep-pass filter (TP) is connected to the input of a loop filter (F), the first and second output of which are connected to the input of a loop filter (F) of which the first and second outputs are connected to an arithmetic unit (RE), and that the output of the arithmetic unit (RE) is connected to the control input of the oscillator (OZ).

13. Phase-locked loop as claimed in Claim 11, **characterised in that** the table entries are integers of n bits each.

**14.** Phase-locked loop as claimed in Claim 11, 12 or 13, **characterised in that** the zero phase angle $\varphi_0$ at the oscillator (OZ) can be set by an offset $n_0$ of the counter by incrementation or decrementation of the counter.

**15.** Phase-locked loop as claimed in any one of Claims 11 to 14, **characterised in that** in order to generate a sinusoidal signal of frequency $f_0$ at a scanning frequency of $f_A$ the increment $\Delta n$ is determined according to the following equation:

$$\Delta n = NINT(N \cdot (f_0/f_A)),$$

wherein the operator NINT signifies rounding to the next higher integer.

**16.** Phase-locked loop as claimed in any one of Claims 11 to 15, **characterised in that** the offset $n_0$ of the counter is calculated from the zero phase angle $\varphi_0$ according to the following equation:

$$n_0 = NINT ((\varphi_0/2\pi) \cdot N).$$

**17.** Phase-locked loop as claimed in any one of Claims 11 to 16, **characterised in that** the counter reading $n(k)$ is calculated at the time $k*T_A$, wherein $T_A = 1/f_A$ and $f_A$ is the scanning frequency, according to the following equation:

$$n(k) = (n(k-1) + \Delta n + n_0(k)) \text{ modulo } N.$$

**18.** Phase-locked loop as claimed in any one of Claims 11 to 17, **characterised in that** a virtual table is used with a length N' which is greater than the length N of the real table, that all counter reading and address calculations are calculated for the virtual table length N', but that only the corresponding most significant bits of the current counter reading $n(k)$ which match the address space of the real table of length N are used for access to the real table.

**19.** Phase-locked loop as claimed in Claim 18, **characterised in that** the counter reading $n_0(k)$ is calculated according to the equation:

$$n_0(k) = NINT(c_p \cdot y_p \cdot (N'/2\pi) + c_i \cdot y_i \cdot (N'/2\pi)),$$

wherein $y_p$ is a second control signal which is generated by the loop filter (F) and is proportional to the first control signal (S), wherein $y_i$ is a third control signal which is generated by the loop filter (F) and is averaged over time from the first control signal (S), and
wherein $c_p$ and $c_i$ are constants for influencing the control behaviour of the phase-locked loop.

**20.** Phase-locked loop as claimed in any one of Claims 11 to 19, **characterised in that** in order to reduce the memory requirement in the table of the counter only a quarter period of a sinusoidal signal is stored.

**21.** Method or phase-locked loop as claimed in any one of Claims 1 to 10, **characterised in that** the useful signal is a stereo multiplex signal and the subcarrier is a pilot tone with a frequency of 19 kHz.

**Revendications**

**1.** Procédé de synchronisation sur une sous-porteuse contenue dans un signal utile (MPX), où
le signal utile (MPX) est multiplié par la composante de quadrature (Q) de la sous-porteuse générée par un oscillateur numérique (OZ), où

le signal (S) résultant - premier signal de régulation - est filtré passe-bas, et le premier signal de régulation filtré passe-bas régule l'oscillateur (OZ), où
l'oscillateur (OZ) est créé à partir d'un tableau de longueur (N) et d'un compteur servant à l'adressage des entrées de tableau, où
les entrées de tableau sont lues avec un pas définissable ($\Delta$n),
**caractérisé en ce qu'**une entrée de tableau LUT(n) figurant à l'adresse n est formée conformément à la formule suivante :

$$LUT(n) = NINT(2^{(nbit-1)} \cdot \sin(2\pi n/N)),$$

où n est un nombre entier compris entre 0 et N-1,
N la longueur du tableau,
nbit la longueur de mot d'une entrée de tableau et où
l'opérateur NINT représente l'arrondi au nombre entier immédiatement supérieur.

2. Procédé selon la revendication 1,
   **caractérisé en ce que** les entrées de tableau sont des nombres entiers de n bits chacun.

3. Procédé selon la revendication 1 ou la revendication 2,
   **caractérisé en ce que** l'angle de phase nul $\varphi$0 sur l'oscillateur (OZ) est réglé par un décalage $n_0$ du compteur, par incrémentation ou décrémentation du compteur.

4. Procédé selon l'une des revendications 1 à 3,
   **caractérisé en ce que**, pour la génération d'un signal sinusoïdal de fréquence $f_0$ pour une fréquence de balayage $f_A$, le pas $\Delta$n est déterminé conformément à la formule suivante :

$$\Delta n = NINT(N \cdot (f_0/f_A)),$$

où l'opérateur NINT représente l'arrondi au nombre entier immédiatement supérieur.

5. Procédé selon l'une des revendications 1 à 4,
   **caractérisé en ce que** le décalage $n_0$ du compteur par rapport à l'angle de phase nul $\varphi$0 est calculé conformément à la formule suivante :

$$n_0 = NINT((\varphi0/2\pi) \cdot N)$$

6. Procédé selon l'une des revendications 1 à 5,
   **caractérisé en ce que** l'index du compteur n(k) au moment $k^*T_A$ est calculé conformément à la formule suivante, $T_A$ étant égal à $1/f_A$ et $f_A$ étant la fréquence de balayage :

$$n(k) = (n(k-1) + \Delta n + n_0(k)) \text{ modulo } N$$

7. Procédé selon l'une des revendications 1 à 6,
   **caractérisé en ce qu'**il est travaillé avec un tableau virtuel de longueur N' supérieure à la longueur N du tableau réel, **en ce que** tous les calculs d'index de compteur et d'adresse sont effectués pour la longueur virtuelle de tableau N', **en ce que** pour l'accès au tableau réel, ne sont toutefois exploités que les bits de poids fort correspondants de l'index de compteur actuel n(k), lesquels correspondent à l'espace d'adressage du tableau réel de longueur N.

8. Procédé selon l'une des revendications 1 à 7,
**caractérisé en ce que** le signal de régulation filtré passe-bas est délivré à un filtre de boucle (F), **en ce qu'**un deuxième signal de régulation ($y_p$) proportionnel au premier signal de régulation (S) et un troisième signal de régulation ($y_i$) sont générés, ce dernier étant une moyenne temporelle du premier signal de régulation (S), et **en ce que** le décalage $n_0$(k) du compteur est calculé à partir du deuxième et du troisième signal de régulation ($y_p$, $y_i$) conformément à la formule suivante :

$$n_0(k) = NINT(c_p.y_p.(N'/2\pi)+c_i.y_i.(N'/2\pi)),$$

où $c_p$ et $c_i$ sont des constantes pour influencer le comportement de régulation

9. Procédé selon l'une des revendications 1 à 8,
**caractérisé en ce que**, pour réduire le besoin de place de mémoire dans le tableau du compteur, seul un quart de période d'un signal sinusoïdal est mémorisé.

10. Procédé selon l'une des revendications 1 à 9,
**caractérisé en ce que** le procédé est réalisé comme logiciel.

11. Circuit de régulation de phase pour la synchronisation sur une sous-porteuse contenue dans un signal utile (MPX), où le signal utile (MPX) est appliqué à la première entrée d'un multiplicateur (M), où
la composante de quadrature (Q) de la première sous-porteuse générée par un oscillateur numérique (OZ) est appliquée sur la deuxième entrée du multiplicateur (M) dont la sortie est reliée aux entrées d'un filtre passe-bas (TP), où
le signal de sortie du filtre passe-bas (TP) est prévu pour la commande de l'oscillateur (OZ), où
l'oscillateur (OZ) est créé à partir d'un tableau de longueur (N) et d'un compteur servant à l'adressage des entrées de tableau, où
les entrées de tableau sont lues avec un pas définissable (Δn),
**caractérisé en ce qu'**une entrée de tableau (LUT(n)) figurant à l'adresse n est formée conformément à la formule suivante :

$$LUT(n) = NINT(2^{(nbit-1)} - \sin(2\pi n/N)),$$

où n est un nombre entier compris entre 0 et N-1,
N la longueur du tableau,
nbit la longueur de mot d'une entrée de tableau et où
l'opérateur NINT représente l'arrondi au nombre entier immédiatement supérieur.

12. Circuit de régulation de phase selon la revendication 11,
**caractérisé en ce que** la sortie du filtre passe-bas (TP) est reliée à l'entrée d'un filtre de boucle (F) dont la première et la deuxième sorties sont reliées à une unité arithmétique (RE), et **en ce que** la sortie de l'unité arithmétique (RE) est reliée à l'entrée de commande de l'oscillateur (OZ).

13. Circuit de régulation de phase selon la revendication 11,
**caractérisé en ce que** les entrées de tableau sont des nombres entiers de n bits chacun.

14. Circuit de régulation de phase selon la revendication 11, 12 ou 13,
**caractérisé en ce que** l'angle de phase nul $\varphi 0$ sur l'oscillateur (OZ) est réglable par un décalage $n_0$ du compteur, par incrémentation ou décrémentation du compteur.

15. Circuit de régulation de phase selon l'une des revendications 11 à 14,

**caractérisé en ce que**, pour la génération d'un signal sinusoïdal de fréquence $f_0$ pour une fréquence de balayage $f_A$, le pas $\Delta n$ est déterminé conformément à la formule suivante :

$$\Delta n = NINT(N.(f_0/f_A)),$$

où l'opérateur NINT représente l'arrondi au nombre entier immédiatement supérieur.

16. Circuit de régulation de phase selon l'une des revendications 11 à 15,
**caractérisé en ce que** le décalage $n_0$ du compteur par rapport à l'angle de phase nul $\varphi 0$ est calculé conformément à la formule suivante :

$$N_0 = NINT((\varphi 0/2\pi).N)$$

17. Circuit de régulation de phase selon l'une des revendications 11 à 16,
**caractérisé en ce que** l'index du compteur $n(k)$ au moment $k*T_A$ est calculé conformément à la formule suivante, $T_A$ étant égal à $1/f_A$ et $f_A$ étant la fréquence de balayage :

$$n(k) = (n(k-1) + \Delta n + n_0(k)) \text{ modulo } N$$

18. Circuit de régulation de phase selon l'une des revendications 11 à 17,
**caractérisé en ce qu'**il est prévu un tableau virtuel de longueur N' supérieure à la longueur N du tableau réel, **en ce que** tous les calculs d'index de compteur et d'adresse sont effectués pour la longueur virtuelle de tableau N', **en ce que** pour l'accès au tableau réel, ne sont toutefois exploités que les bits de poids fort correspondants de l'index de compteur actuel $n(k)$, lesquels correspondent à l'espace d'adressage du tableau réel de longueur N.

19. Circuit de régulation de phase selon la revendication 18,
**caractérisé en ce que** l'index de compteur $n_0(k)$ est calculé conformément à la formule suivante :

$$n_0(k) = NINT(c_p.y_p.(N'/2\pi)+c_i.y_i.(N'/2\pi)),$$

où $y_p$ est un deuxième signal de régulation généré par le filtre de boucle (F), proportionnel au premier signal de régulation (S),
où $y_i$ est un troisième signal de régulation généré par le filtre de boucle (F) à partir du premier signal de régulation (S) mis temporellement à la moyenne,
et où $c_p$ et $c_i$ sont des constantes pour influencer le comportement de régulation du circuit de régulation de phase.

20. Circuit de régulation de phase selon l'une des revendications 11 à 19,
**caractérisé en ce que**, pour réduire le besoin de place de mémoire dans le tableau du compteur, seul un quart de période d'un signal sinusoïdal est mémorisé.

21. Procédé ou circuit de régulation de phase selon l'une des revendications 1 à 10,
**caractérisé en ce que** le signal utile (MPX) est le signal stéréo multiplex et la sous-porteuse de la tonalité pilote avec une fréquence de 19 KHz.

Fig.

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 0512606 A2
- DE 19738914 A1
- US 4703340 A
- EP 0516379 A2